# EUROPEAN PATENT SPECIFICATION

(11) **EP 3 274 310 B1**
(45) Date of publication and mention of the grant of the patent: **08.05.2019**
(21) Application number: 16712430.4
(22) Date of filing: 23.03.2016
(51) Int. Cl.: C03C 3/087, H01L 31/02, H01L 31/0296, H01L 31/032, H01L 31/0392, H01L 31/048

(54) **NOVEL GLASSES**
NEUE GLÄSER
VERRES NOUVEAUX

(30) Priority: 26.03.2015 GB 201505096
(43) Date of publication of application: 31.01.2018
(73) Proprietor: Pilkington Group Limited, Nr. Ormskirk, Lancashire L40 5UF (GB)
(72) Inventor: HORSLEY, Martin James, Helsby Cheshire WA6 0PR (GB); TAYLOR, Shona, Ormskirk Lancashire L40 5TF (GB)
(74) Representative: Pettet, Nicholas Edward
(86) International application number: PCT/GB2016/050815
(87) International publication number: WO 2016/151324

(56) References cited:
- WO-A1-98/49111
- CN-B- 102 718 404
- US-A- 6 063 718
- US-A1- 2011 203 645
- US-B1- 6 627 569

## Description

The present invention relates to glass, more specifically to novel glasses, novel glass compositions and to substrates composed of the novel glass compositions. The novel glass compositions are soda lime silica glasses, but possess relatively high strain points compared with known soda lime silica glasses, in particular those soda lime silica glasses which are in common use to produce flat glass by the float process. Consequently, the novel glasses of the invention are suited to applications requiring good dimensional stability at high temperatures, such as fire protection glazings and substrates for processing at high temperature. The substrates are suitable for the deposition of coatings and the manufacture of display panels, discs, e.g. magnetic recording discs, semiconductor devices, including photovoltaic cells, especially solar cells, amongst other applications.

While normal soda lime silica glass (i.e. soda lime silica glass compositions in common use for windows and other glazings for buildings and vehicles) has suitable properties at room temperature for many of the above applications, the applications may require processing of the glass at high temperatures, i.e. at temperatures which are above the strain point, or the annealing point, or even the softening point of the glass. Processing the glass at such elevated temperatures would result in the creation of permanent internal stresses in the glass, possibly leading to distortion or fracture of the glass. The glass may even become distorted or deformed during processing. Attempts have therefore been made to provide glasses which are more suited to high temperature processing, i.e. which possess improved high temperature stability by virtue of having relatively high strain points.

The strain point (which is defined as the temperature at which the viscosity of the glass is 10^{14.5} poise, denoted T log 14.5 poise) of soda lime float glass in common use is in the region of about 510° C to 540° C, depending on the precise composition. However, many glasses with higher strain points are known. One group of glasses with high strain points is the so-called alkali-free glasses. Unfortunately, these glasses are difficult and expensive to produce, owing to the lack of alkali which acts as a flux. Many of these glasses are also unsuitable for forming by the float process. The use of alternative forming processes generally adds further to the cost, and may result in inferior flatness or smoothness of the surface. A further problem with alkali-free glasses is that they tend to have very low coefficients of thermal expansion, which renders them unsuitable for some applications.

Another group of glasses with relatively high strain points contains increased potash and reduced soda, compared with common or "normal" soda lime silica float glass. ZrO₂ Unfortunately, high potash glasses are themselves difficult to produce in the open regenerative furnaces generally employed in float plants, because high potash glasses may be difficult to refine in such furnaces.

A number of attempts have been made to provide a soda lime silica glass composition having a higher strain point than common float glass. US 5,599,754 discloses a glass composition for a substrate, which is useful for flat display panels, particularly for plasma display panels. The claimed compositions contain from 6 to 9% SrO, which is expensive, and adds significantly to the cost of raw materials when used at these relatively high levels.

US 6,905,991 is an example of a soda lime silica glass composition containing relatively low levels of soda (from 2 to 8% Na₂O) and relatively high levels of potash (from 0-8%, but all of the Examples contain at least 3.5% K₂O). The resulting glasses may be used for producing fireproof glazing panels or for substrates for display panels.

WO 98/49111 discloses a glass composition for a plasma display panel, the glass having a lower density than previous glasses for plasma display panels. The total amount of BaO and SrO included in the total alkaline earth metal oxides in the glass lies in the range of 1 to 8%. Again, these oxides are expensive.

US 6,087,284 relates to an aluminosilicate glass which is suitable for use in display technology. This patent seeks to find a glass which has a high transition temperature, low density and is solarisation-stable. Preferably the glass contains MgO in trace levels at most, or not at all. It therefore represents a substantial departure from the composition of normal or common float glass.

US 7,273,668 relates to a glass composition having high heat resistance which is suitable for chemical strengthening. The composition may be used to produce glass substrates for magnetic recording media, e.g. hard disk drives. Unfortunately this glass is prone to devitrification, which can make manufacturing difficult, and reduce yields.

KR 2009 0111680 A discloses a glass composition for display panels, which seeks to improve reactivity and failure rate of electrode patterns.

JP 2010 143790 A discloses a method for producing a glass substrate for a solar cell in which waste glass can be efficiently recycled. The waste glass is used as part of the glass raw material, which is then melted in a glass melting furnace and formed into the glass substrate.

US 8,828,897 relates to aluminosilicate glasses having high thermal stability and low processing temperatures. The glasses may be used as substrate glass, superstrate glass and/or cover glass for photovoltaic applications and other solar technology applications.

US 8,895,463 relates to a glass substrate for a solar cell such as a Cu-In-Ga-Se ("CIGS) solar cell. The glass compositions of the invention deviate significantly from common soda lime silica glass, being low in soda and high in potash.

US 2013/0306145 A1 also relates to a glass substrate for a CIGS solar cell, and again, the glass compositions are low in soda and high in potash.

US 2013/0313671 A1 relates to glass substrates for solar cells, such as CdTe or CIGS cells. It is stated that the content of SrO, BaO, B₂O₃ and/or ZrO₂ is advantageously zero in order not to penalise the cost of the glass sheet. However, judging by the Examples provided, this approach yields only modest increases in strain point compared with common soda lime silica glass.

WO98/49111 A1 discloses soda lime silica glasses having a high strain point which can be used for plasma display panels.

CN102718404 B discloses soda lime silica glasses having a high strain point which can be used for photovoltaic cells.

It would be desirable to provide novel glasses which achieve a substantial increase in strain point without a substantial increase in the cost of the glass. The cost of glass comprises the cost of the raw materials together with the cost of converting them into finished glass sheets, which itself comprises elements such as the cost of fuel, labour, the plant employed, its level of efficiency, the yields obtained, etc. It would therefore further be desirable to provide novel glass compositions which achieve a substantial increase in strain point and are also able to be readily manufactured by the float process, since this process is a very efficient way of making flat glass. The desired novel glass compositions are therefore ones which lend themselves to economic manufacture.

It has surprisingly been found that the addition of ZrO₂ to a normal float glass composition yields a substantial increase in the strain point of the glass.

According to the present invention there is provided a glass having a composition comprising the following oxides (in weight %):

| | |
|---|---|
| SiO₂ | 61 to 69% |
| Al₂O₃ | 0 to 8% |
| Na₂O | 10 to 13% |
| K₂O | 0 to 1% |
| MgO | 2 to 6% |
| CaO | 7 to 13% |
| SrO | 0 to 1% |
| ZrO₂ | 2 to 13% |
| TiO₂ | 0 to 1%. |

It has also been found that increasing the amount of Al₂O₃ in the glass composition, in addition to increasing the amount of ZrO₂, further increases the strain point of the glass.

Glasses according to the invention are suitable for processing at higher temperatures than normal float glass. The inventive glasses are less susceptible to deformation or distortion at elevated temperatures, and so have higher dimensional stability and improved heat resistance.

Advantageously, the glass composition comprises from 3 to 12% ZrO₂, preferably from 3 to 11% ZrO₂, more preferably from 4 to 11% ZrO₂, still more preferably from 5 to 10% ZrO₂, yet more preferably from 5 to 9% ZrO₂, most preferably from 6 to 9% ZrO₂. Particularly suitable glass compositions may contain from 7 to 9% ZrO₂. Optionally, such glass compositions may also contain from 2 to 6% Al₂O₃, preferably from 3 to 5% Al₂O₃. Since zirconia (ZrO₂) is more expensive than other raw materials employed in the manufacture of float glass, this allows glasses according to the invention to be tailored to achieve the desired balance between performance and cost.

Optionally, the glass composition is free of any one, or any number, of the following oxides: As₂O₃, BaO, B₂O₃, BeO, CeO₂, Er₂O₃, GeO₂, Li₂O, P₂O₅, PbO, Sb₂O₃, SnO₂, SrO, TiO₂, V₂O₅, ZnO. These oxides may be objectionable for reasons of toxicity, cost or their adverse effect on the furnace structure. However, traces of these oxides may be present as a result of impurities in the raw materials. In particular, the glass composition may contain from 0 to 1% BaO or B₂O₃. In many of the applications contemplated, it is not necessary or not desirable to tint the glass, so in such cases the glass is free of colourants, e.g. CdO, CeO₂, CoO, Co₃O₄, Cr₂O₃, CuO, Er₂O₃, MnO₂, Nd₂O₃, NiO, Se, V₂O₅.

Preferably, a glass according to the invention has a strain point greater than 570° C, preferably greater than 580° C, more preferably greater than 590° C. As mentioned above, it is desirable to provide glasses which are readily manufactured by the float process. Therefore, while increasing the strain point of a glass, it is also important to take account of other properties of the glass, such as melting temperature, liquidus temperature and working range, which determine how readily the glass may be melted and formed. Surprisingly, the inventors were able to tailor all these properties simultaneously, to provide glasses with high strain points and favourable manufacturing properties.

Preferably, a glass according to the invention has a melting temperature (defined as the temperature at which the viscosity is 100 poise, i.e. log 2 poise, denoted T log 2 poise) less than 1500° C, preferably less than 1480° C, more preferably less than 1460° C. This allows the raw materials to be melted and turned into glass without excessive fuel usage and without causing undue wear to the structure of the furnace in which the glass is melted.

Advantageously, a glasses according to the invention has a liquidus temperature less than 1200° C, preferably less than 1180° C, more preferably less than 1160° C, yet more preferably less than 1140° C, still more preferably less than 1120° C, most preferably less than 1100° C. A lower liquidus temperature reduces the risk of devitrification in molten glass in the cooler regions of the furnace. The term "devitrification" refers to the formation of crystals such as wollastonite (abbreviated to "Woll." in Table I below) or diopside in the glass, which is undesirable because such crystals may end up in the final product, causing it to be rejected.

Desirably, a glass according to the invention has a working range (defined as the forming temperature, T log 4 poise, minus the liquidus temperature) greater than -100° C, preferably greater than -80° C, more preferably greater than -60° C, yet more preferably greater than -40° C, still more preferably greater than -20° C, most preferably greater than 0° C, i.e. most preferably the working range is positive. Some glass forming processes are more tolerant of a negative working range than others, and the float glass process is able to operate with a negative working range. A less negative, or more positive, working range facilitates forming of the molten glass into a product (e.g. a ribbon of flat glass) without devitrification occurring.

It is advantageous for the physical properties of the final product (e.g. sheet of glass, glass substrate, display panel, disc, etc) to be suited to the particular application for which the glass is intended. For some of these applications, normal soda lime silica glass possesses suitable physical properties at room temperature, but, as mentioned previously, it cannot be processed at sufficiently high temperatures without negative effects. According to an additional aspect of the invention, glasses are provided which not only have increased strain points, and lend themselves to economic manufacture, but also retain suitable physical properties at room temperature.

For instance, according to this aspect of the invention, a glass is provided having a coefficient of thermal expansion from 70 to 90 x 10⁻⁷ °C⁻¹ (50-350° C), preferably from 72 to 88 x 10⁻⁷ °C⁻¹ (50-350° C), more preferably from 74 to 86 x 10⁻⁷ °C⁻¹ (50-350° C), and most preferably from 76 to 84 x 10⁻⁷ °C⁻¹ (50-350° C).

Moreover, properties such as density and refractive index are also important when the glass produced by a furnace is changed over from one composition to another. A changeover of particular significance is the changeover from normal float glass to a glass according to the invention. Such changeovers are carried out "on the run", i.e. the mixture of raw materials fed to the furnace is changed to the mixture which is appropriate for the new composition without draining the furnace or stopping melting. The time taken for the changeover can be reduced if both glass compositions have similar density and refractive index, since mixing of the two compositions then occurs more readily.

It is therefore also desirable to provide a glass having a density from 2.50 to 2.70 g cm⁻³ at 25° C, preferably from 2.51 to 2.69 g cm⁻³ at 25° C, more preferably from 2.52 to 2.68 g cm⁻³ at 25° C, further preferably from 2.53 to 2.67 g cm⁻³ at 25° C, yet more preferably from 2.54 to 2.66 g cm⁻³ at 25° C, most preferably from 2.55 to 2.66 g cm⁻³ at 25° C.

Similarly, it is desirable if a glass according to the invention has a refractive index from 1.50 to 1.62, preferably from 1.51 to 1.60, more preferably from 1.52 to 1.59, more preferably from 1.53 to 1.58.

The invention also encompasses glass articles having a glass composition according to the claims appended, and in particular a sheet of glass formed from glass having a glass composition as claimed herein. Furthermore, the invention also includes a glass substrate comprising glass having a glass composition as claimed herein, and any of the products manufactured using such a glass substrate, including but not limited to a display panel, a disc, a semiconductor device and a photovoltaic cell, especially a solar cell. Glass substrates according to the invention may be used for CdTe and CIGS (Cu-In-Ga-Se) solar cells amongst others.

The invention will now be further described with reference to the following nonlimiting Examples set out in Table 1. In the table, Examples 8-10, 12 and 13 are according to the invention, and Examples 1 to 7, 11 and 14 to 20 are comparative examples. In particular, Example 1 is representative of normal float glass, and has a strain point of 536° C. In contrast, Examples 2 to 20 have strain points ranging from 574° C to 595° C, and the Examples according to the invention span a slightly reduced range of strain points from 577° C to 594° C.

Although Example 13 has a strain point of 594° C, i.e. one degree lower than Comparative Example 7, the glass composition of Example 13 has the considerable advantage of a positive working range, which outweighs one degree difference in strain point. Examples 10 and 11 also have favourable working ranges, and indeed none of Examples 8 to 13 should be regarded as having unfeasibly negative working ranges.

Another attractive feature of glasses according to the invention is their low liquidus temperature, especially Examples 10, 12 and 13. Thus a variety of ZrO₂-containing compositions is provided, offering a range of physical properties to suit different applications. Additionally, Example 12 benefits from a low melting temperature, while Examples 8 and 11 have a high temperature viscosity profile similar to that of normal float glass, with the advantage that only small changes to normal furnace operation would be required to melt this inventive glass composition.

Novel glasses having glass compositions according to the invention therefore offer a considerably increased strain point while retaining suitable manufacturing and room temperature properties, rendering them suitable for high temperature processing and other applications requiring increased dimensional stability at elevated temperatures.

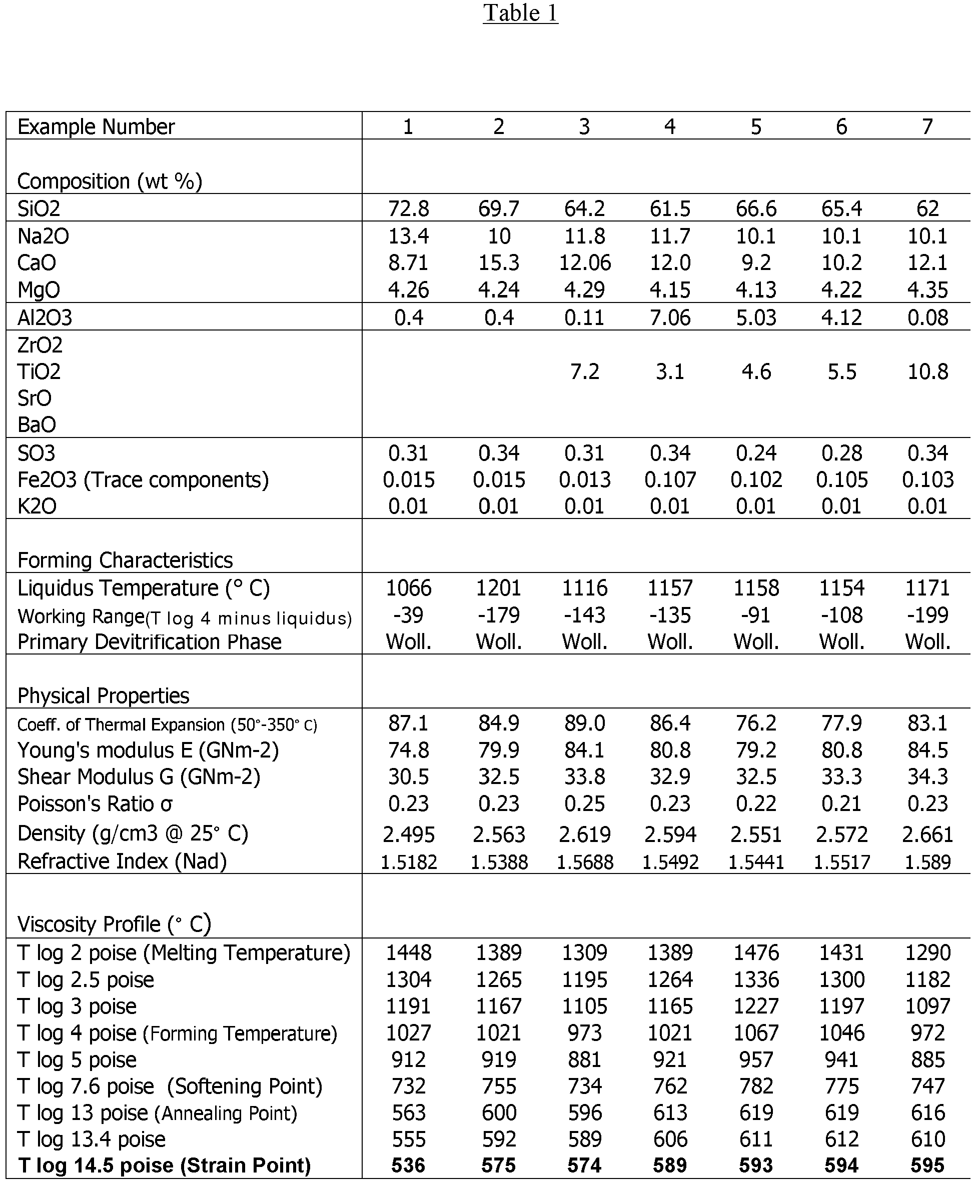

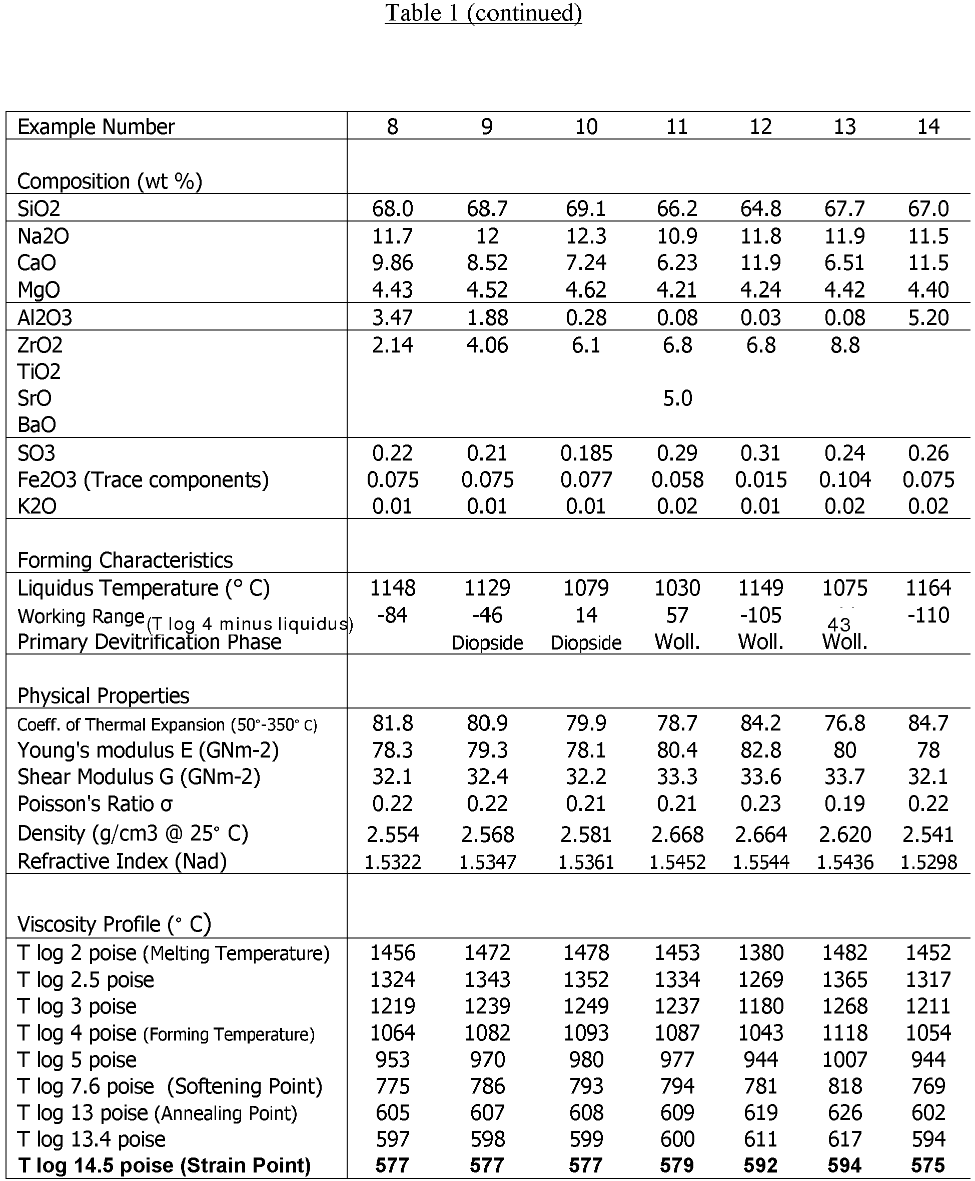

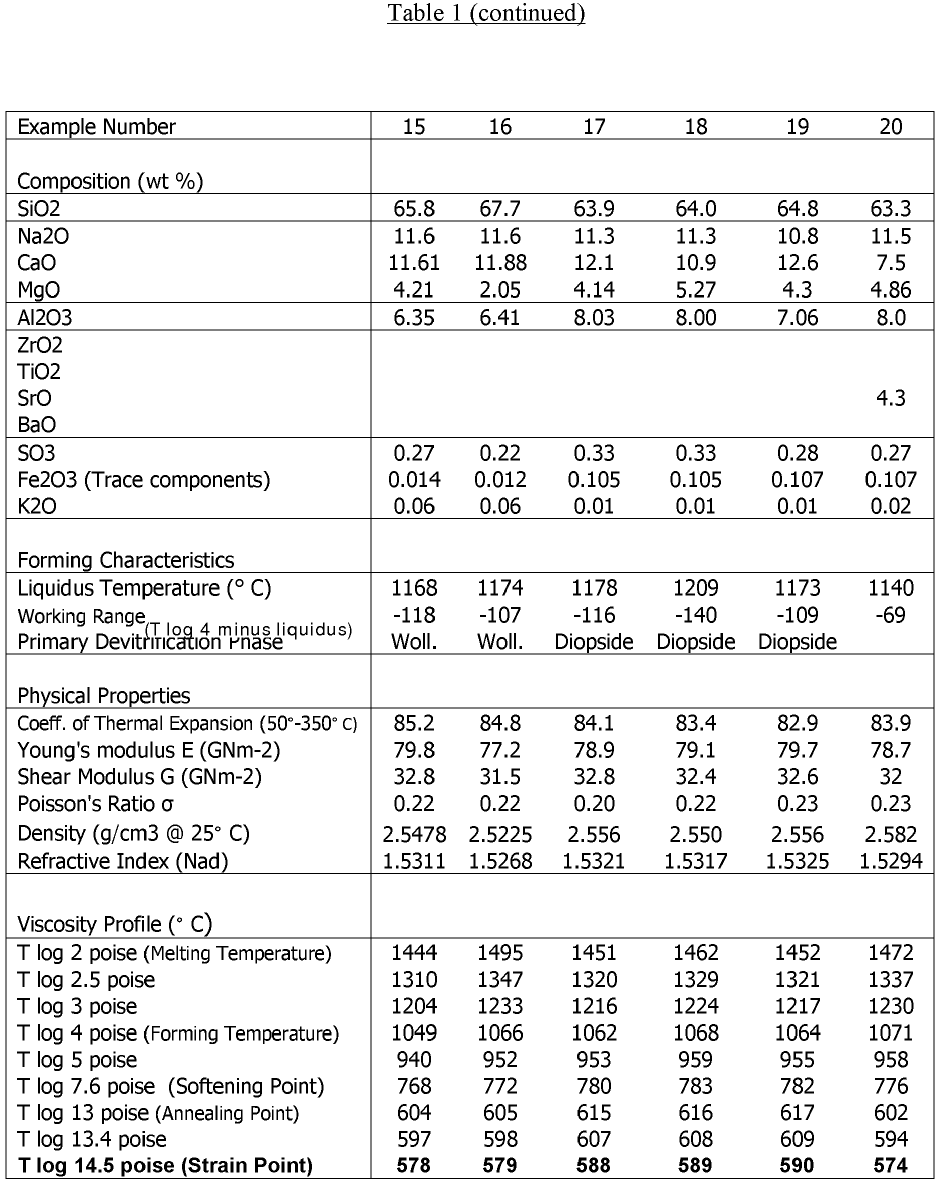

## Claims

1. A glass having a composition comprising the following oxides (in weight %):
| | |
|---|---|
| SiO₂ | 61 to 69% |
| Al₂O₃ | 0 to 8% |
| Na₂O | 10 to 13% |
| K₂O | 0 to 1% |
| MgO | 2 to 6% |
| CaO | 7 to 13% |
| SrO | 0 to 1% |
| ZrO₂ | 2 to 13% |
| TiO₂ | 0 to 1%. |

2. A glass as claimed in claim 1, comprising from 3 to 12% ZrO₂, preferably from 3 to 11% ZrO₂, more preferably from 4 to 10% ZrO₂, most preferably from 6 to 10% ZrO₂.

3. A glass as claimed in any preceding claim having a strain point greater than 570° C, preferably greater than 580° C, more preferably greater than 590° C.

4. A glass as claimed in any preceding claim having a melting temperature (at which viscosity = log 2 poise) less than 1500° C, preferably less than 1480° C, more preferably less than 1460° C.

5. A glass as claimed in any preceding claim having a liquidus temperature less than 1200° C, preferably less than 1180° C, more preferably less than 1160° C, yet more preferably less than 1140° C, still more preferably less than 1120° C, most preferably less than 1100° C.

6. A glass as claimed in any preceding claim having a working range (defined as T log 4 poise minus the liquidus temperature) greater than -100° C, preferably greater than -80° C, more preferably greater than -60° C, yet more preferably greater than -40° C, still more preferably greater than -20° C, most preferably greater than 0° C.

7. A glass as claimed in any preceding claim having a coefficient of thermal expansion from 70 to 90 x 10⁻⁷ °C⁻¹ (50-350° C), preferably from 74 to 86 x 10⁻⁷ °C⁻¹ (50-350° C).

8. A glass as claimed in any preceding claim having a density from 2.50 to 2.70 g cm⁻³ at 25° C, preferably from 2.52 to 2.68 g cm⁻³ at 25° C, more preferably from 2.54 to 2.66 g cm⁻³ at 25° C.

9. A glass as claimed in any preceding claim having a refractive index from 1.50 to 1.62, preferably from 1.52 to 1.59, more preferably from 1.53 to 1.58.

10. A sheet of glass formed from glass as claimed in any preceding claim.

11. A glass substrate comprising glass as claimed in claims 1 to 9.

12. A photovoltaic cell comprising the glass substrate of claim 11.

## Patentansprüche

1. Glas mit einer Zusammensetzung, die die folgenden Oxide (in Gew.-%) umfasst:
| | |
|---|---|
| SiO₂ | 61 bis 69%, |
| Al₂O₃ | 0 bis 8%, |
| Na₂O | 10 bis 13%, |
| K₂O | 0 bis 1%, |
| MgO | 2 bis 6%, |
| CaO | 7 bis 13%; |
| SrO | 0 bis 1%, |
| ZrO₂ | 2 bis 13%, |
| TiO₂ | 0 bis 1%. |

2. Glas nach Anspruch 1, umfassend 3 bis 12% ZrO₂, vorzugsweise 3 bis 11% ZrO₂, bevorzugter 4 bis 10% ZrO₂, am bevorzugtesten 6 bis 10% ZrO₂.

3. Glas nach einem der vorhergehenden Ansprüche mit einem unteren Kühlpunkt oberhalb von 570° C, vorzugsweise oberhalb von 580° C, stärker bevorzugt oberhalb von 590° C.

4. Glas nach einem der vorhergehenden Ansprüche mit einer Schmelztemperatur (bei der die Viskosität = log 2 Poise ist) von weniger als 1500° C, vorzugsweise weniger als 1480° C, stärker bevorzugt weniger als 1460° C.

5. Glas nach einem der vorhergehenden Ansprüche mit einer Liquidustemperatur von weniger als 1200°C, vorzugsweise weniger als 1180° C, stärker bevorzugt weniger als 1160° C, noch stärker bevorzugt weniger als 1140° C, noch stärker bevorzugt weniger als 1120° C, am bevorzugtesten weniger als 1100° C.

6. Glas nach einem der vorhergehenden Ansprüche mit einem Arbeitsbereich (definiert als T log 4 Poise minus der Liquidustemperatur) oberhalb von -100 °C, vorzugsweise oberhalb von -80 °C, bevorzugter oberhalb von -60 °C, noch bevorzugter oberhalb von -40 °C, nochmals bevorzugter oberhalb von -20 °C, meistbevorzugt oberhalb von 0° C.

7. Glas nach einem der vorhergehenden Ansprüche mit einem Wärmeausdehnungskoeffizienten von 70 bis 90 x 10⁻⁷ °C⁻¹ (50-350 °C), vorzugsweise 74 bis 86 x 10⁻⁷ °C⁻¹ (50-350 °C).

8. Glas nach einem der vorhergehenden Ansprüche mit einer Dichte von 2,50 bis 2,70 g cm⁻³ bei 25°C, vorzugsweise von 2,52 bis 2,68 g cm⁻³ bei 25° C, vorzugsweise von 2,54 bis 2,66 g cm⁻³ bei 25° C.

9. Glas nach einem der vorhergehenden Ansprüche mit einem Brechungsindex von 1,50 bis 1,62, vorzugsweise von 1,52 bis 1,59, besonders bevorzugt von 1,53 bis 1,58.

10. Glasscheibe, die aus Glas nach einem der vorhergehenden Ansprüche gebildet ist.

11. Glassubstrat mit Glas nach den Ansprüchen 1 bis 9.

12. Photovoltaikzelle mit dem Glassubstrat nach Anspruch 11.

## Revendications

1. Verre ayant une composition comprenant les oxydes suivants (en % en poids) :
| | |
|---|---|
| SiO₂ | 61 à 69 % |
| Al₂O₃ | 0 à 8 % |
| Na₂O | 10 à 13 % |
| K₂O | 0 à 1 % |
| MgO | 2 à 6 % |
| CaO | 7 à 13 % |
| SrO | 0 à 1 % |
| ZrO₂ | 2 à 13 % |
| TiO₂ | 0 à 1 %. |

2. Verre selon la revendication 1, comprenant de 3 à 12 % de ZrO₂, de préférence de 3 à 11 % de ZrO₂, de manière davantage préférée de 4 à 10 % de ZrO₂, de manière préférée entre toutes de 6 à 10 % de ZrO₂.

3. Verre selon une quelconque revendication précédente, ayant un point de trempe supérieur à 570 °C, de préférence supérieur à 580 °C, de manière davantage préférée supérieur à 590 °C.

4. Verre selon une quelconque revendication précédente, ayant une température de fusion (à laquelle viscosité = log 2 poises) inférieure à 1 500 °C, de préférence inférieure à 1 480 °C, de manière davantage préférée inférieure à 1 460 °C.

5. Verre selon une quelconque revendication précédente, ayant une température de liquidus inférieure à 1 200 °C, de préférence inférieure à 1 180 °C, de manière davantage préférée inférieure à 1 160 °C, de manière encore davantage préférée inférieure à 1 140 °C, de manière encore plus préférée inférieure à 1 120 °C, de manière préférée entre toutes inférieure à 1 100 °C.

6. Verre selon une quelconque revendication précédente, ayant une plage de travail (définie par T log 4 poises moins la température de liquidus) supérieure à -100 °C, de préférence supérieure à -80 °C, de manière davantage préférée supérieure à -60 °C, de manière encore davantage préférée supérieure à -40 °C, de manière encore plus préférée supérieure à -20 °C, de manière préférée entre toutes supérieure à 0 °C.

7. Verre selon une quelconque revendication précédente, ayant un coefficient de dilatation thermique de 70 à 90 x 10⁻⁷ °C⁻¹ (50 à 350 °C), de préférence de 74 à 86 x 10⁻⁷ °C⁻¹ (50 à 350 °C).

8. Verre selon une quelconque revendication précédente, ayant une masse volumique de 2,50 à 2,70 g cm⁻³ à 25 °C, de préférence de 2,52 à 2,68 g cm⁻³ à 25 °C, de manière davantage préférée de 2,54 à 2,66 g cm⁻³ à 25 °C.

9. Verre selon une quelconque revendication précédente, ayant un indice de réfraction de 1,50 à 1,62, de préférence de 1,52 à 1,59, de manière davantage préférée de 1,53 à 1,58.

10. Feuille de verre formée à partir de verre selon une quelconque revendication précédente.

11. Substrat de verre comprenant du verre selon l'une quelconque des revendications 1 à 9.

12. Cellule photovoltaïque comprenant le substrat de verre de la revendication 11.
